# EUROPEAN PATENT APPLICATION

(11) **EP 2 784 784 A1**
(43) Date of publication of application: **01.10.2014**
(21) Application number: 12852414.7
(22) Date of filing: 19.11.2012
(51) Int. Cl.: H01B 1/22, B22F 9/24, H01L 31/042

(54) **PASTE COMPOSITION FOR FRONT SURFACE ELECTRODE OF SOLAR CELL AND SOLAR CELL USING SAME**

(30) Priority: 21.11.2011 KR 20110121741
(71) Applicant: Hanwha Chemical Corporation, Seoul 100-220 (KR)
(72) Inventor: PAIK, Choong Hoon, Daejeon 305-720 (KR); SON, Won-Il, Seoul 138-220 (KR); SIM, You-Jin, Daejeon 305-748 (KR)
(74) Representative: Smaggasgale, Gillian Helen
(86) International application number: PCT/KR2012/009792
(87) International publication number: WO 2013/077605

(57) **Abstract**

The present invention relates to a paste composition for a front electrode of a solar cell comprising nano silver powder surface-treated with hexanoic acid, and a solar cell comprising a front electrode formed using the paste composition.

According to the present invention, a front electrode is formed using a paste composition containing nano silver powder surface-treated with hexanoic acid, thereby decreasing resistance of a front electrode and broadening an area capable of absorbing light, to improve solar cell efficiency.

## Description

### [Technical Field]

The present invention relates to a paste composition for a front electrode of a solar cell, and a solar cell using the same, more particularly, to a paste composition comprising nano silver powder, and a solar cell including a front electrode formed using the same and comprising nano silver powder.

### [Background Art]

Recently, with the expectation of depletion of existing energy resources such as petroleum or coal, interests in alternative energy capable of replacing them are increasing. Among them, a solar cell is getting the spotlight as a next generation cell using a semiconductor device directly converting sunlight energy into electrical energy.

A solar cell is largely divided into a silicon solar cell, a compound semiconductor solar cell, and a tandem solar cell. Among them, a silicon solar cell makes the mainstream

Meanwhile, a front electrode of a silicon solar cell is generally formed using a paste containing silver powder, an organic binder, glass frit, and the like. However, in case this method is used, it may be difficult to secure electrode pattern property of a certain degree because the viscosity of the paste may be lowered when a large amount of additives are introduced to achieve thixotropy of paste.

Accordingly, there is a demand for development of a solar cell having increased aspect ratio of a front electrode while satisfying electrode pattern of a certain degree, and a solar cell using the same.

### [Disclosure]

### [Technical Problem]

It is an object of the present invention to provide a method for preparing nano silver powder surface-treated with hexanoic acid, and a paste composition for a front electrode of a solar cell comprising the same

It is another object of the present invention to provide a solar cell with decreased front electrode resistance and improved solar cell efficiency, by using the paste composition for a front electrode comprising nano silver powder surface-treated with hexanoic acid, improving discharageability from mesh when screen printing, thus forming a front electrode having narrow line width and increased line height thus having high aspect ratio.

### [Technical Solution]

To achieve the objects, the present invention provides a method for preparing nano silver powder comprising
forming a silver precursor solution comprising a silver precursor, a hydroxyl group-free organic solvent and hexanoic acid; and
reducing the silver precursor solution in liquid phase to form silver nanoparticles surface-treated with hexanoic acid.

For the nano silver powder, silver nanoparticles surface-treated with 1 to 10 wt% of hexanoic acid based on total weight of the nano silver powder may be preferably formed.

The step of forming the silver precursor solution may preferably include introducing 0.1~30 wt% of a silver precursor, 25~50 wt% of a hydroxyl group-free organic solvent, and 25~50 wt% of hexanoic acid into a semi-continuous reactor, and mixing them. In addition, the silver precursor solution may be formed at a reaction temperature of 40∼80°C.

Further, the step of forming silver nanoparticles surface-treated with hexanoic acid may include
(a) introducing 0.01∼5 wt% of a reducing agent into the silver precursor solution to form silver nanoparticles surface-treated with hexanoic acid by liquid phase reduction by a semi-continuous process; and
(b) injecting mixed gas of oxygen and nitrogen into the reactor such that the oxygen concentration in the reactor may become 200~300 ppm.

The reducing agent may be preferably introduced at a speed of 1~100 ml/min.

The method may further include, after the step (a), controlling pH to 10~12 using an amine based solvent as a pH control agent. In addition, the method may further include, after the step (b), introducing ethanol and centrifuging to recover silver nanoparticles surface-treated with hexanoic acid; and keeping the recovered silver nanoparticles in a hydroxyl group-free organic solvent.

The silver precursor may be preferably selected from the group consisting of silver acetate, silver cyclohexanebutyrate, silver 2-ethylhexanoate, silver neodecanoate and silver acetylacetonate. The hydroxyl group-free organic solvent may be at least one selected from the group consisting of toluene, xylene, benzene, nitrobenzene and nitrotoluene. The reducing agent may be at least one selected from the group consisting of hydrazine, sodium hypophosphate, sodium hypophosphite, and sodium borohydride.

According to another embodiment of the invention, provided is a paste composition for a front electrode of a solar cell comprising
60~95 wt% of silver powder having average particle size (d₅₀) of 1.7~3.2µm;
0.5~20 wt% of nano silver powder surface-treated with hexanoic acid, having average particle size (d₅₀) of 10~80 nm, prepared according to the above method;
0.1~8 wt% of glass frit having average particle size (d₅₀) of 0.5~2µm;
1~20 wt% of a binder; and
1~20 wt% of a solvent.

In addition, the paste composition may further include at least one metal selected from the group consisting of Ti, Bi, Co, Zn, Zr, Fe and Cr, metal oxide or metal hydride thereof in an amount of 1~5 parts by weight, based on 100 parts by weight of the paste composition.

Furthermore, the paste composition may further include 1 to 20 parts by weight of at least one additive selected from the group consisting of a dispersant, a thickener, a thixotropic agent, and a leveling agent, based on 100 parts by weight of the paste composition.

According to yet another embodiment of the invention, provided is a solar cell comprising
a silicon semiconductor substrate;
an emitter layer formed on the substrate;
an anti-reflection layer formed on the emitter layer;
a front electrode penetrating the anti-reflection layer from the top of the anti-reflection layer and connecting to the emitter layer; and
a rear electrode formed on the bottom of the substrate,
wherein the front electrode is formed using the above-explained paste composition comprising nano silver powder surface-treated with hexanoic acid.

The front electrode may have the aspect ratio of 0.2 to 0.4.

### [Advantageous Effects]

According to the present invention, since a paste for a front electrode includes silver nanoparticles surface-treated with hexanoic acid that is a protecting agent of a C6 organic molecular main chain, together with silver powder, the width of a front electrode may be decreased and the height may be increased to increase the aspect ratio, thus decreasing resistance of a front electrode, and broadening an area capable of absorbing light, to improve solar cell efficiency.

### [Description of Drawings]

Fig. 1 schematically shows the structure of a solar cell according to one example.
Fig. 2 shows the particle diameter distribution of nano silver powder when introducing a reducing agent at 10 ml/min according to Example 1.
Fig. 3 shows the particle diameter distribution of nano silver powder when introducing a reducing agent at 30 ml/min according to Example 2.
Fig. 4 shows the particle diameter distribution of nano silver powder when introducing a reducing agent at 50ml/min according to Example 3.
Fig. 5 shows the particle diameter distribution of nano silver powder when introducing a reducing agent at 100ml/min according to Example 4.
Fig. 6 shows comparison of resistivity properties to sintering temperature change after screen printing pastes comprising nano silver powders of Examples 1 to 4.
Fig. 7 shows the height and width of a front electrode manufactured using the paste composition comprising nano silver powder of Examples 6~9 and Comparative Example 1.
Fig. 8 is the cross-section SEM analysis result of the front electrode manufactured in Comparative Example 1.
Fig. 9 is the cross-section SEM analysis result of the front electrode obtained in Example 9.

### [Best Mode]

Hereinafter, the present invention will be explained in detail.

The present invention uses nano silver powder surface-treated with hexanoic acid together with common silver powder in a paste composition, to increase the aspect ratio of a front electrode of a solar cell.

Specifically, the present invention relates to a paste composition that may largely improve solar cell efficiency by increasing the aspect ratio of a front electrode of a solar cell, decreasing resistance, and broadening an area capable of absorbing light, thereby largely improving solar cell efficiency, using nano silver powder surface-treated with hexanoic acid, and a solar cell comprising a front electrode formed using the same.

As used herein, nano silver powder refers to silver powder surface-treated with hexanoic acid.

Hereinafter, a method for preparing nano silver powder surface-treated with hexanoic acid, and a paste composition comprising nano silver powder prepared by the method will be explained in detail.

According to preferred embodiment of the invention, provided is a method for preparing nano silver powder comprising: forming a silver precursor solution comprising a silver precursor, a hydroxyl group-free organic solvent and hexanoic acid; and reducing the silver precursor solution in liquid phase to form silver nanoparticles surface-treated with hexanoic acid.

The nano silver powder is surface-treated with a protectant of an organic molecular main chain having C6 carbon backbone, and it may be synthesized by liquid phase reduction by a semi-continuous process as explained above.

The protectant of an organic molecular main chain having C6 carbon backbone functions as a capping molecule of silver powder, and as the protectant, hexanoic acid (CH₃(CH₂)₄COOH, C₆) is used.

Specifically, to prepare the nano silver powder of the present invention, a silver precursor solution comprising a silver precursor, a solvent, hexanoic acid and a reducing agent is used.

The step of forming the silver precursor solution includes introducing 0.1~30 wt% of the silver precursor, 25~50 wt% of the hydroxyl group-free organic solvent, and 25~50 wt% of the hexanoic acid into a semi-continuous reactor, and mixing them.

In addition, in the step of forming the silver precursor solution, a nano silver precursor solution may be preferably formed by mixing each ingredient in a semi-continuous reactor as explained above, and stirring while maintaining a reaction temperature of 40 to 80 °C.

Furthermore, the step of forming the silver nanoparticles surface-treated with hexanoic acid may include
(a) introducing 0.01~5 wt% of a reducing agent into the silver precursor solution to form silver nanoparticles surface-treated with hexanoic acid by liquid phase reduction by a semi-continuous process; and
(b) injecting mixed gas of oxygen and nitrogen into the reactor such that the oxygen concentration in the reactor may become 200~300 ppm.

In the step of forming silver nanoparticles surface-treated with hexanoic acid, in case a reducing agent is introduced, it may be introduced into a silver precursor solution at a constant introduction speed using a metering pump, and through the process, nanosized silver particles are prepared. Wherein, particle size may be controlled by controlling the introduction speed of the reducing agent and reaction temperature.

In the present invention, nano silver powder having an average particle diameter, i.e. average particle size (d₅₀) of 10 - 80nm may be preferably prepared. Nano silver powder having particle size of less than 10nm may be excessively surface treated to increase viscosity when preparing a paste, and if the particle size of nano silver powder is greater than 80nm, sintering temperature may be increased to increase resistance of a front electrode.

Thus, to prepare nano silver powder having the above average particle size, silver nanoparticles surface-treated with hexanoic acid having the above particle diameter range may be prepared by controlling the reaction temperature to 40 - 80°C, more preferably 40 ~ 60°C, and the introduction speed of a reducing agent to 1 ~ 100ml/min, more preferably 10 ~ 50ml/min.

In addition, when the introduction of the reducing agent is completed, to control hexanoic acid surface treatment amount of nano silver powder, mixed gas of oxygen and nitrogen is injected to the oxygen concentration of 200 to 300ppm, more preferably 250ppm, using a mass flow controlled in the reactor, and purged for 1 to 10 minutes. It may be preferable that vaporized solvents may be condensed during the reaction, and generated gas may be discharged outside through a condenser. Wherein, the ratio of the mixed gas of oxygen and nitrogen may be appropriately controlled so as to reach the above oxygen concentration.

Furthemore, if necessary, the method may further include, after the step (b), introducing ethanol and centrifuging to recover silver nanoparticles surface-treated with hexanoic acid; and keeping the recovered silver nanoparticles in a hydroxyl group-free organic solvent.

Preferably, after the introduction of the reducing agent is completed, a post-reaction may be progressed for 10~30 minutes to completely react un-reacted substances. After the reaction is completed, ethanol (95%) is introduced, and the synthesized nano silver powder particles surface-treated with hexanoic acid are recovered using a centrifuge.

By the process, nano silver powder surface-treated with hexanoic acid is provided, and preferably, the nano silver powder may be formed of silver nanoparticles surface-treated with 1 to 10 wt% of hexanoic acid based on total weight of the nano silver powder.

Meanwhile, as the silver precursor used in the silver precursor solution, silver salt that does not include anion such as sulfur (S²⁻) or chlorine (Cl⁻), and the like, which may cause problems of short-circuit when a front electrode is formed, may be preferably used. Specific examples of the silver precursor may include silver acetate (silverC₂H₃O₂), silver cyclohexanebutyrate, silver 2-ethylheanoate, silver neodecanoate, silver acetylacetonate, and the like. The content may be preferably 0.1∼30 wt% based on total weight of the nano silver precursor solution. If the silver precursor is less than 0.1 wt%, productivity may be lowered, and if it is greater than 30 wt%, solubility of silver salt is exceeded, and it may be precipitated and may not be dissolved

The hydroxyl group-free organic solvent may be at least one selected from the group consisting of toluene, xylene, benzene, nitrobenzene and nitrotoluene. The content may be preferably 25~50 wt% based on total weight of the nano silver precursor solution. If the content of the organic solvent is less than 25 wt%, solubility of silver salt may be lowered, and if it is greater than 50 wt%, productivity may be lowered.

As the hexanoic acid, those commercially available may be used, and the content may be preferably 25 to 50 wt% based on total weight of the nano silver precursor solution. If the content of hexanoic acid is less than 25 wt%, uniform nanosized particles surface-treated with hexanoic acid may not be formed, and if it is greater than 50 wt%, a solvent for dissolving hexanoic acid may become too much to lower productivity of nano silver powder (nanoparticles produced per unit time).

The reducing agent may be at least one selected from the group consisting of hydrazine, sodium hypophosphate, sodium hypophosphite, and sodium borohydride. More preferably, potent reducing agent hydrazine may be used. The content of the reducing agent may be 0.01∼5 wt% based on total weight of the nano silver precursor solution. If the content is less than 0.01 wt%, reduction of silver salt may be very slowly progressed to increase the size of nano silver powder, and if it is greater than 5 wt%, reaction of copper salt may vigorously occur to broaden particle size distribution of nano silver powder.

In case hydrazine is used as the reducing agent, it is not dissolved in a hydroxyl group-free organic solvent, e.g., toluene, and thus, a co-solvent and a pH control agent may be further added. Thus, the method may further include, after the step (b), controlling pH to 10~12 using an amine based solvent as a pH control agent. The amines may be used as a co-solvent and a pH control agent, and may include butylamine, monoethanolamine, and the like. When the amines are used, the content is not specifically limited as long as it may control pH of the silver nano precursor solution to 10~12.

In addition, if necessary, the nano silver precursor solution may further include at least one selected from the group consisting of a surfactant and additives, and the content is not specifically limited. For example, the content may be 0.1 to 3 parts by weight, based on 100 parts by weight of the nano silver precursor solution.

Meanwhile, according to another embodiment of the invention, provided is a paste composition for a front electrode of a solar cell comprising 60~95 wt% of silver powder having average particle size (d₅₀) of 1.7∼3.2µm; 0.5~20 wt% of nano silver powder surface-treated with hexanoic acid, having average particle size (d₅₀) of 10~80 nm, prepared according to the above explained method; 0.1∼8 wt% of glass frit having average particle size (d₅₀) of 0.5∼2µm; 1∼20 wt% of a binder; and 1∼20 wt% of a solvent.

The silver powder affords conductivity to the paste, and the shape may include a spherical shape, a flake shape, and the like without specific limitation, but spherical shape is preferable. The content of silver powder may be 60 to 95 wt%, based on total weight of the paste composition. If the content is less than 60 wt%, a front electrode pattern obtained from the paste may not have sufficient conductivity, and if it is greater than 95 wt%, printing may become difficult due to too high viscosity.

In addition if average particle size(d₅₀) of silver powder is less than 1.7µm, flowability of the paste may be lowered to decrease operability, and if it is greater than 3.21µm, pores may be generated in the electrode after firing, to increase electric resistance of the front electrode.

The nano silver powder surface-treated with hexanoic acid may be included in the content of 0.5 to 20 wt%, based on total weight of the paste composition. In addition, as explained above, since the nano silver powder has average particle size (d₅₀) of 10 to 80nm, it may be easily adsorbed to a solvent and a binder, and the like due to high specific surface area to easily increase viscosity of paste even with a small amount, and it may prevent spreadability of paste and maintain high viscosity rate so as to satisfy the aspect ratio of a front electrode of a solar cell. If the content of the nano silver powder is less than 0.5 wt%, the above explained effects may not be sufficiently achieved, and if it is greater than 20 wt%, printability of electrode pattern may be lowered due to too high viscosity of paste.

The glass frit may be included in the content of 0.1 to 8 wt%, based on total weight of the paste composition. If the content of the glass frit is less than 0.1 wt%, adhesive strength of the formed electrode pattern may not be sufficient, and if it is greater than 8 wt%, sinterability of electrode pattern may be lowered to increase resistance of the electrode. In addition, to effectively form sintered pattern without pin holes, the average particle size (d₅₀) may be 0.5 to 2 µm. Specific examples of the glass frits may include lead oxide and/or bismuth oxide. Specifically, it may be one selected from the group consisting of SiO₂-PbO based, SiO₂-PbO-B₂O₃ based and Bi₂O₃-B₂O₃-SiO₂ based powders, or a mixture thereof, but is not limited thereto. In addition, to improve adhesion to an emitter layer, at least one metal selected from the group consisting of Ti, Bi, Co, Zn, Zr, Fe and Cr, metal oxide or metal hydroxide thereof may be further included in an amount of 1 to 5 parts by weight, based on 100 parts by weight of the paste composition.

The binder is used as binding material of each ingredient before firing, and it may be preferably prepared by suspension polymerization for uniformity. The binder may include a carboxylic acid group-containing resin, specifically, a carboxylic acid group-containing photosensitive resin that has an ethylenic unsaturated double bond per se, and a carboxylic acid group-containing resin that does not have an ethylenic unsaturated double bond. Specific examples of the binder may include i) a carboxylic acid group-containing photosensitive resin obtained by copolymerization of unsaturated carboxylic acid and a compound having an unsaturated double bond, ii) a carboxylic acid group-containing photosensitive resin obtained by addition of an ethylenic unsaturated group to a copolymer of a compound having an unsaturated double bond and unsaturated carboxylic acid as a pendant, iii) a carboxylic acid group-containing photosensitive resin obtained by reacting a compound having a hydroxyl group and an unsaturated double bond with a copolymer of acid anhydride having an unsaturated double bond and a compound having an unsaturated double bond, but is not limited thereto, and a combination there of may be used.

The binder may be preferably included in the content of 1 to 20 wt%, based on total weight of the paste composition. If the content of the binder is less than 1 wt%, distribution of the binder in the formed electrode pattern may become non-uniform, and thus, patterning by selective exposure and development may become difficult, and if it is greater than 20 wt%, pattern may be easily collapsed when firing the electrode, and resistance of the electrode may be increased due to carbon ash after firing.

In addition, as the solvent used in the paste composition for a front electrode, any solvent that may dissolve the binder and is mixed well with other additives may be used. Specific examples of the solvent may include those containing an aldehyde group such as α-terpineol, butyl carbitol acetate, texanol, butyl carbitol and dipropylene glycol monoethylether, and the like, but not limited thereto. The solvent may be included in the remaining amount, based on total weight of the paste compostion, and it may be preferably included in the content of 1 to 20 wt%. If the content of the solvent is less than 1 wt%, it may be difficult to uniformly apply paste, and if it is greater than 20 wt%, electrode pattern may not have sufficient conductivity, and adhesion to a substrate may be lowered.

Besides, the paste composition for a front electrode may further include additives such as a dispersant, a thickener, a thixotropic agent, and a leveling agent, and the like, and the content of the additives may be 1 to 20 parts by weight, based on 100 parts by weight of the paste composition.

Meanwhile, according to yet another embodiment of the invention, provided is a solar cell comprising a silicon semiconductor substrate; an emitter layer formed on the substrate; an anti-reflection layer formed on the emitter layer; a front electrode penetrating the anti-reflection layer from the top of the anti-reflection layer and connecting to the emitter layer; and a rear electrode formed on the bottom of the substrate, wherein the front electrode is formed using the above explained paste composition comprising nano silver powder surface-treated with hexanoic acid.

Hereinafter, a solar cell according to one embodiment of the invention will be explained in more detail with reference to drawings.

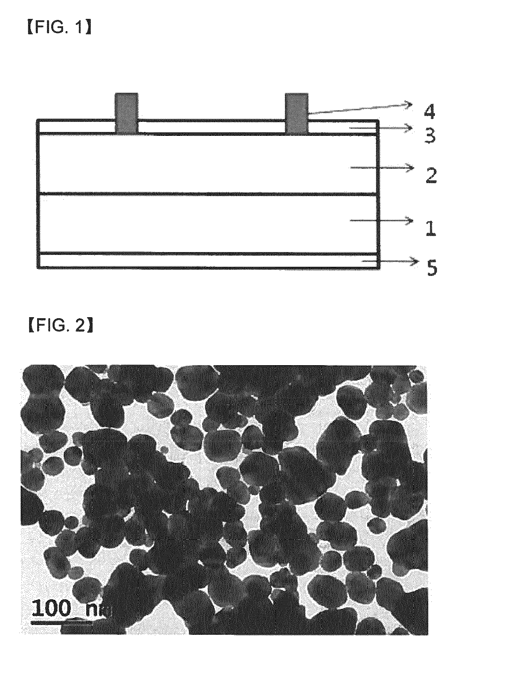

Fig. 1 schematically shows the structure of a solar cell according to one example. Referring to Fig. 1, the solar cell of the present invention includes a silicon semiconductor substrate(1) (hereinafter referred to as a substrate), an emitter layer(2) formed on top of the substrate(1), an anti-reflection layer(3) formed on the emitter layer(2), and a front electrode(4) penetrating the anti-reflection layer(3) and connecting to the emitter layer(2), and a rear electrode(5) on the bottom of the substrate(1).

The substrate(1) may be dopped with p-type impurities such as Group III atoms B, Ga, In, and the like, and the emitter layer(2) may be dopped with n-type impurities such as Group IV atoms P, As, Sb, and the like. As such, if the substrate(1) and the emitter layer(2) are dopped with opposite conductive type impurities, a P-N junction is formed at the interface of the substrate(1) and the emitter layer(2).

The anti-reflection layer(3) passivates defects existing on the surface of the emitter layer(2) or in the bulk, and decreases reflectance of sun light entering into the front of the substrate(1). If defects existing in the emitter layer(2) are passivated, recombination site of a few carriers may be removed to increase open circuit voltage (Voc) of a solar cell. In addition, it reflectance of sun light is decreased, the amount of light reaching the P-N junction may be increased to increase short-circuit current (Isc) of a solar cell. As such, if open circuit voltage and short-circuit current of a solar cell are increased by the anti-reflection layer(3), conversion efficiency of a solar cell may be improved to that extent. The anti-reflection layer(3) may have a single layer structure of one selected from the group consisting of a silicon nitride layer, a silicon oxide layer, a silicon oxide nitride layer, MgF₂, ZnS, TiO₂ and CeO₂, or a multi-layer structure of two or more thereof, but is not limited thereto. The anti-reflection layer(3) may be formed by vacuum deposition, chemical vapor deposition, spin coating, screen printing or spray coating.

In addition, the front electrode(4) may include silver, and may be formed using silver powder having average particle size(d₅₀) of 1.7∼3.2µm together with nano silver power surface-treated with hexanoic acid, having average particle size(d₅₀) of 10~80 nm.

Specifically, the front electrode(4) may be formed by screen printing a paste for a front electrode on the front electrode(4) forming point, and then, heat treating. Wherein, through a firing process of the electrode, silver included in the metal paste becomes liquid phase at high temperature and recrystallizes to solid phase, and connects to the emitter layer(2) by punch through phenomenon whereby it penetrates the anti-reflection layer(3) by glass frit. The heat treatment may be progressed by firing at 100 to 600°C, but is not limited thereto, and heat treatment may be progressed by well known methods in this field.

Meanwhile, as shown in Fig. 1, the front electrode(4) is positioned uppermost of a solar cell and hides sun light. Thus, it is important to minimize the area of the front electrode(4) without lowering the function, and the paste for a front electrode(4) according to the present invention may easily maintain the shape of the front electrode(4) by using silver powder and nano silver powder surface-treated with hexanoic acid. As the result, the aspect ratio of the front electrode(4) is increased to decrease resistance of a front electrode(4), broaden the area capable of absorbing light, thus improving solar cell efficiency. Namely, since the present invention uses the above explained paste composition when screen printing, discharageability from mesh is improved to form a front electrode having narrow width and increased height, thus having high aspect ratio, and a solar cell comprising the same with decreased resistance of a front electrode and improved efficiency may be provided. Preferably, the aspect of the front electrode may be 0.2 to 0.4. Wherein, silver powder remains between the electrodes, hexanoic acid is removed by heat treatment to form a pure silver electrode, thus improving conductivity.

In addition the rear electrode(5) may include aluminum, but is not limited. For example, the rear electrode(5) may be formed by printing a paste for a rear electrode including aluminum, quartzsilica, binder, and the like on the rear side of the substrate(1) and then heat treating. By heat treatment of the rear electrode(5), electrode forming material aluminum may be diffused through the rear side of the substrate(1), thus forming a back surfacefield layer at the interface of the rear electrode(5) and the substrate(1). If the back surfacefield layer is formed, migration and recombination of carriers to the rear side of the substrate(1) may be prevented, thus increasing open circuit voltage to improve solar cell efficiency.

Hereinafter, the present invention will be explained in more detail by the following Examples. However, these Examples are only to illustrate the invention, and the right scope of the invention is not limited thereto.

### Example 1 ∼ 4

A silver precursor solution was prepared with the composition and contents of the following Table 1, and nano silver powder surface-treated with hexanoic acid was prepared by liquid phase reduction.

As a silver precursor, silver acetate (silver acetate, silverC₂H₃O₂, silver content 68%, Junsei) was used, as a capping molecule, hexanoic acid (C₆H₁₂O₂) was used (hereinafter, referred to as "C₆" for convenience). In addition, as a hydroxyl group-free organic solvent, toluene was used, and as a reducing agent, hydrazine (N₂H₄ · H₂O) was used.

**[Table 1]**

| Raw material | Weight (g) |
|---|---|
| silver acetate (silverC₂H₃O₂) | 26 |
| hexanoic acid (C₆) | 533 |
| Toluene | 800 |
| N₂H₄ · H₂O(ml/min) | 10 |

Specifically, silver acetate, C₆ and toluene were added in a semi-continuous reactor to prepare a silver nano precursor solution.

Subsequently, the silver nano precursor solution was stirred while maintaining temperature of 40°C, and a reducing agent hydrazine was introduced into the silver nano precursor solution at a constant introduction speed of Table 1 using a metering pump to prepare silver nanoparticles. In addition as a pH control agent, butyl amine was added to the composition of Table 1 so that pH may become 9. Wherein, the introduction amount of the reducing agent at a reaction temperature of 40 °C was controlled as in the following Table 3.

At the end of the introduction of the reducing agent, to control the C₆ surface treatment amount in silver powder, a mixed gas of oxygen (O₂) and nitrogen (N₂) was purged in the reactor for 5 minutes using a mass flow controlled such that the oxygen concentration may become 250ppm. Vaporized solvent during the reaction was condensed, and generated gas was discharged outside through a condenser. After the introduction of the reducing agent was completed, a post-reaction was progressed for 20 minutes to completely react non-reacted substances. After the reaction was completed, 500ml of ethanol (95%) was introduced, and silver nanoparticles surface-treated with C₆ was recovered using a centrifuge. In addition, the recovered silver nanoparticles were kept in toluene.

Wherein, Examples 1 to 4 were distinguished according to the introduction amount of the reducing agent and the C₆ surface treatment amount.

### Example 5

An silver precursor solution was prepared with the composition and content of the following Table 2, and nano silver powder surface-treated with hexanoic acid was prepared by liquid phase reduction.

As a silver precursor, silver 2-ethylhexanoate (silverC₈H₁₅O₂) was used, as an organic solvent, toluene was used, and as a reducing agent, sodium borohydride (NaBH₄) was used.

**[Table 2]**

| Raw materials | weight(g) |
|---|---|
| silver 2-ethylhexanoate (silverC₈H₁₅O₂) | 37.65 |
| Hexanoic acid (C₆) | 533 |
| Toluene | 800 |
| Sodium borohydride (NaBH₄) | 8.5 |

Specifically, silver acetate, C₆ and toluene were added in a semi-continuous reactor to prepare an silver nano precursor solution.

Subsequently, the silver nano precursor solution was stirred while maintaining temperature of 40 °C, and a reducing agent of sodium borohydride was introduced into the silver precursor solution to prepare silver nanoparticles. In addition, as a pH control agent, butyl amine was added to the composition of Table 2 so that pH may become 9. At the end of the introduction of the reducing agent, to control the C₆ surface treatment amount in silver powder, a mixed gas of oxygen (O₂) and nitrogen (N₂) was purged in the reactor for 5 minutes using a mass flow controlled such that the oxygen concentration may become 250ppm. Vaporized solvent during the reaction was condensed, and generated gas was discharged outside through a condenser. After the introduction of the reducing agent was completed, a post-reaction was progressed for 20 minutes to completely react non-reacted substances. After the reaction was completed, 500ml of ethanol (95%) was introduced, and silver nanoparticles surface-treated with C₆ was recovered using a centrifuge. In addition, the recovered silver nanoparticles were kept in toluene.

### Experimental Example 1

The recovered particles were completely dried in a vacuum oven for 24 hours, and the particle diameter and C₆ surface treatment amount were measured as follows. To measure C₆ surface treatment amount, the particles were analyzed using a Thermogravimetry Analyzer and the results are described in Table 3. In addition, silver nanoparticles surface-treated with C₆ were magnified 50,000-fold using transmission electron microscope, and the particle diameter of the silver nanoparticle surface-treated with C₆ was measured.

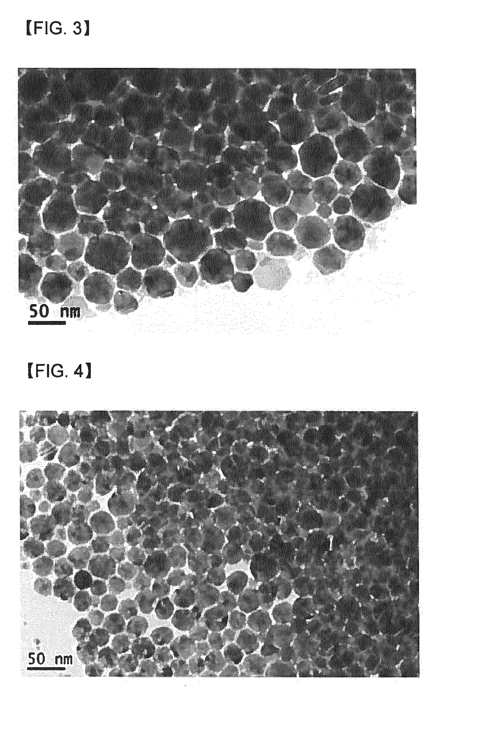

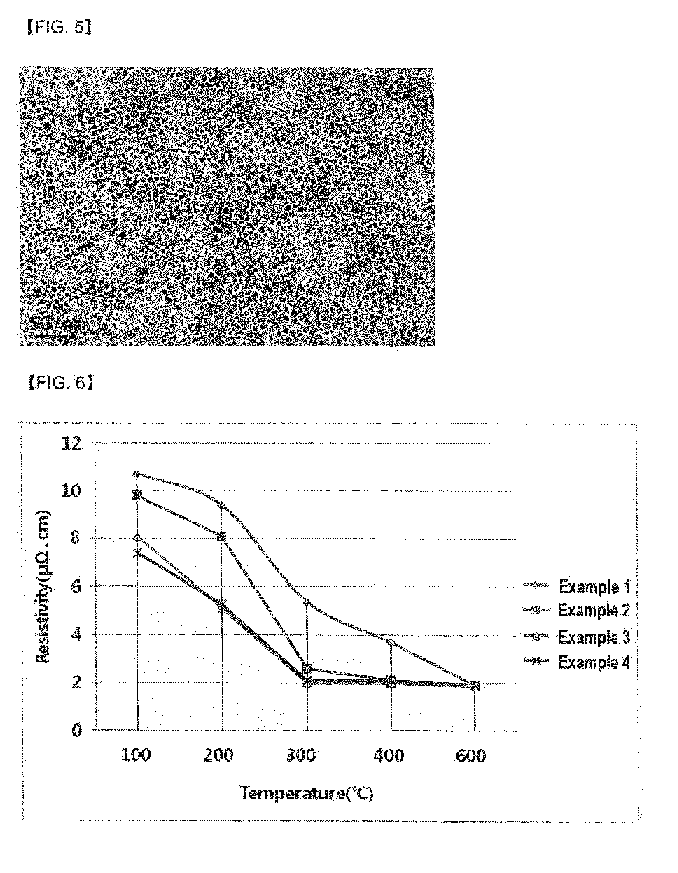

In addition, change in particle diameter according to introduction speed of the reducing agent was shown in Figs. 2 to 5. Fig. 2 shows particle diameter distribution of nano silver powder when the reducing agent was introduced at 10 ml/min according to Example 1, and Fig. 3 shows particle diameter distribution of nano silver powder when the reducing agent is introduced at 30ml/min according to Example 2. Furthermore, Fig. 4 shows particle diameter distribution of nano silver powder when the reducing agent is introduced at 50ml/min according to Example 3, and Fig. 5 shows particle diameter distribution of nano silver powder when the reducing agent is introduced at 100ml/min according to Example 4.

**[Table 3]**

| | Introduction speed of reducing agent (ml/min) | Average particle size (D50,nm) | Standard deviation | C₆ surface treatment amount (wt%) |
|---|---|---|---|---|
| Example 1 | 10 | 80 ±10nm | 9.8 | 1.5 |
| Example 2 | 30 | 50 ±8nm | 13.1 | 2.7 |
| Example 3 | 50 | 30 ±5nm | 7.2 | 5.4 |
| Example 4 | 100 | 10 ±1nm | 9.1 | 10.2 |
| Example 5 | 8.5* | 50 ±13nm | 9.4 | 2.1 |
| * in Example 5, introduced as g/min | | | | |

As shown in Table 3, it was confirmed that the nano silver powder surface-treated with C₆ has average particle size of 10~80nm according to introduction speed of a reducing agent, and that nano silver powder surface-treated with C₆ having surface treatment amount of 1∼10 wt% is prepared.

### Experimental Example 2

### Measurement of resistivity (electrical conductivity) of silver nano powder surface-treated with C₆

To measure resistivity (electrical conductivity) of nano silver powder surface-treated with C₆, manufactured in Examples 1 to 5, a silver paste was prepared.

85 wt% of silver nanoparticles surface-treated with C₆, 10 wt% of butylcarbitol acetate, 3 wt% of a binder (ethyl cellulose resin, product name Ethocel, Dow Company, Standard 100), and 2 wt% of a dispersant (BYK-180) were mixed by 3-roll milling to prepare a paste. Screen printing was conducted using the prepared paste, and resistivity was measured according to sintering temperature. In addition, after screen printing the paste comprising the nano silver powder of Examples 1 to 5, resistivity properties according to change in sintering temperature were compared, and the results are shown in Fig. 6 and Table 4 (unit: µΩ· cm). The measurement method is as follows.
* Sheet resistance: measured using 4 point probe
**: Thickness: measured using SEM or α-step
***: resistivity = Sheet resistance x Thickness

**[Table 4]**

| | Resistivity (µΩ · cm) | | | | |
|---|---|---|---|---|---|
| Temperature(°C) | Example 1 | Example 2 | Example 3 | Example 4 | Example 5 |
| 100 | 10.7 | 9.8 | 8.1 | 7.4 | 12.1 |
| 200 | 9.4 | 8.1 | 5.1 | 5.3 | 10.4 |
| 300 | 5.4 | 2.6 | 2.0 | 2.1 | 7.8 |
| 400 | 3.7 | 2.1 | 2.0 | 2.1 | 4.1 |
| 600 | 1.9 | 1.9 | 1.9 | 1.9 | 2.1 |

As shown in Fig. 6 and Table 4, in case silver nano powder surface-treated with C6 of Example 4 having the smallest average particle diameter is used, decrease rate of resistivity was much larger, and in all cases, resistivity was excellent.

In addition, at a temperature above 300°C, rapid decrease in resistivity (improvement in electrical conductivity) occurred. Since an organic molecule (C₆) that protected the surface of silver nanoparticles surface-treated with C₆ is desorbed by heat and simultaneously decomposed, if a front electrode is formed using the same, an electrode including silver substantially free of organic substance C₆ as a main ingredient is obtained, thus forming a front electrode with excellent electrical conductivity.

### Example 6

4 wt% of the nano silver powder surface-treated with C6 obtained in Example 4, 5 wt% of SiO₂-PbO-B₂O₃ glass frit, 10 wt% of butyl carbitol acetate, 3 wt% of a binder ((ethyl Cellouse resin, product name Ethocel, Dow Company, Standard 100), 79 wt% of silver powder having average particle size (D50) of 3.21µm (Dowa) were mixed and dispersed. The mixed dispersion was dispersed by 3-roll milling to prepare a paste. The prepared paste was printed on a silicon semiconductor substrate using a screen printer, and then, sintered in a 700 °C belt firing furnace for 20 seconds to form a front electrode(4) of Fig. 1. The cross section of the formed front electrode(4) was analyzed with SEM (scanning electron microscope).

### Example 7

A paste was prepared by the same method as Example 6, except that 8 wt% of the nano silver powder obtained in Example 4 and 75 wt% of silver powder were used.

### Example 8

A paste was prepared by the same method as Example 6, except that 13 wt% of the nano silver powder obtained in Example 4 and 70 wt% of silver powder were used.

### Example 9

A paste was prepared by the same method as Example 6, except that 17 wt% of the nano silver powder obtained in Example 4 and 66 wt% of silver powder were used.

### Comparative Example 1

A paste was prepared by the same method as Example 6, except that nano silver powder was not used, and 83 wt% of common silver powder was used only.

### Experimental Example 3

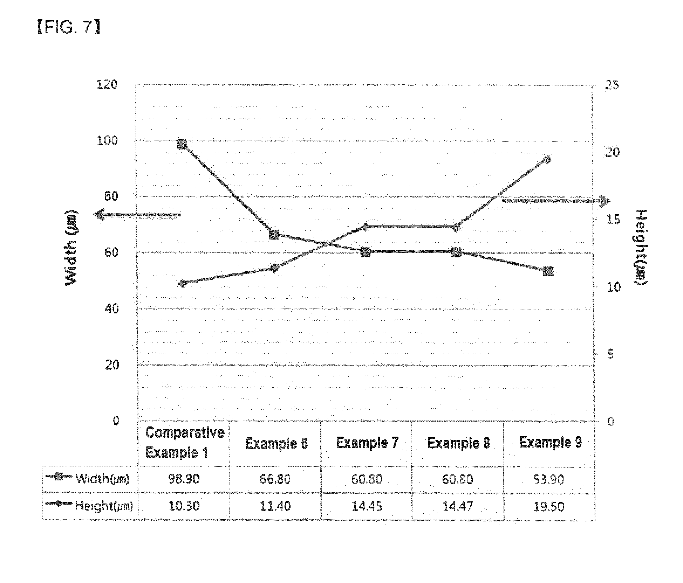

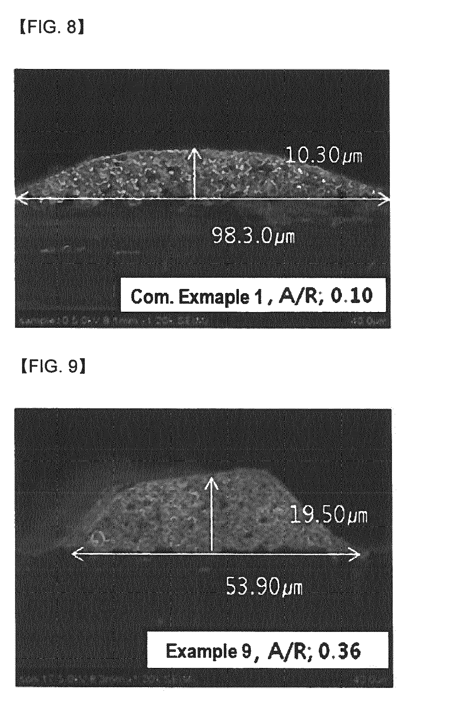

Fig. 7 shows the heights and the widths of the front electrodes manufactured using the paste compositions containing the nano silver powder of Examples 6~9 and Comparative Example 1. Fig. 8 show SEM analysis result of the cross section of the front electrode manufactured in Comparative Example 1, and Fig. 9 shows SEM analysis result of the cross section of the front electrode obtained in Example 9.

**[Table 5]**

| | Comparative Example 1 | Example 6 | Example 7 | Example 8 | Example 9 |
|---|---|---|---|---|---|
| Height (*µ*m) | 10.3 | 11.4 | 14.5 | 14.5 | 19.5 |
| Width (*µ*m) | 98.9 | 66.8 | 60.8 | 60.8 | 53.9 |
| Aspect ratio (A/R) | 0.1 | 0.2 | 0.2 | 0.2 | 0.4 |
| Resistivity (µΩ·cm) | 4.5 | 3.0 | 2.6 | 2.4 | 2.3 |
| Cell efficiency (%) | 17.0 | 17.1 | 17.3 | 17.5 | 17.9 |

As shown in Figs. 7-9, in Examples 6 to 9 using nano silver powder surface-treated with C₆, width of the front electrode is decreased compared to Comparative Example 1, and height is increased, and thus, aspect ratio (A/R) is increased.

As shown in Table 5, if the aspect ratio of the front electrode(4) is less than 0.1, resistivity of the front electrode(4) is increased, and solar cell efficiency is low. To the contrary, as the content of nano silver powder surface-treated with C₆ in the front electrode(4) is increased, the aspect ratio is increased, resistivity is decreased, and thus, photoelectric conversion efficiency of a solar cell is improved.

### [Description of code]

- 1:: silicon semiconductor substrate
- 2:: emitter layer
- 3:: anti-reflection layer
- 4:: front electrode
- 5:: rear electrode

## Claims

1. A method for preparing nano silver powder comprising
forming a silver precursor solution comprising a silver precursor, a hydroxyl group-free organic solvent and hexanoic acid; and
reducing the silver precursor solution in liquid phase to form silver nanoparticles surface-treated with hexanoic acid.

2. The method for preparing nano silver powder according to claim 1, wherein silver nanoparticles surface-treated with 1 to 10 wt% of hexanoaic acid based on total weight of the nano silver powder are formed.

3. The method for preparing nano silver powder according to claim 1, wherein the step of forming the silver precursor solution comprises introducing 0.1∼30 wt% of the silver precursor, 25~50 wt% of the hydroxyl group-free organic solvent, and 25~50 wt% of the hexanoic acid into a semi-continuous reactor, and mixing them.

4. The method for preparing nano silver powder according to claim 3, wherein the silver precursor solution is formed at a reaction temperature of 40~80°C.

5. The method for preparing nano silver powder according to claim 1, wherein the step of forming silver nanoparticles surface-treated with hexanoic acid comprises
(a) introducing 0.01∼5 wt% of a reducing agent into the silver precursor solution to form silver nanoparticles surface-treated with hexanoic acid by liquid phase reduction by a semi-continuous process; and
(b) injecting mixed gas of oxygen and nitrogen into the reactor such that the oxygen concentration in the reactor becomes 200~300 ppm.

6. The method for preparing nano silver powder according to claim 5, wherein the reducing agent is introduced at a speed of 1∼100 ml/min.

7. The method for preparing nano silver powder according to claim 5, further comprising, after the step (a), controlling pH to 10~12 using an amine based solvent as a pH control agent.

8. The method for preparing nano silver powder according to claim 5, further comprising, after the step (b), introducing ethanol and centrifuging to recover silver nanoparticles surface-treated with hexanoic acid; and keeping the recovered silver nanoparticles in a hydroxyl group-free organic solvent,

9. The method for preparing nano silver powder according to claim 1, wherein the silver precursor is selected from the group consisting of silver acetate, silver cyclohexanebutyrate, silver 2-ethylhexanoate, silver neodecanoate, and silver acetylacetonate.

10. The method for preparing nano silver powder according to claim 1, wherein the hydroxyl group-free organic solvent is selected from the group consisting of toluene, xylene, benzene, nitrobenzene and nitrotoluene.

11. The method for preparing nano silver powder according to claim 5, wherein the reducing agent is at least one selected from the group consisting of hydrazine, sodium hypophosphate, sodium hypophosphite, and sodium borohydride.

12. A paste composition for a front electrode of a solar cell comprising 60~95 wt% of silver powder having average particle size (d₅₀) of 1.7∼3.2µm;
0.5~20 wt% of nano silver powder surface-treated with hexanoic acid, having average particle size (d₅₀) of 10~80 nm, prepared according to any one of claims 1 to 11;
0.1~8 wt% of glass frit having average particle size (d₅₀) of 0.5~2µm;
1~20 wt% of a binder; and
1~20 wt% of a solvent.

13. The paste composition for a front electrode of a solar cell according to claim 12, further comprising at least one metal selected from the group consisting of Ti, Bi, Co, Zn, Zr, Fe and Cr, metal oxide or metal hydride thereof in an amount of 1~5 parts by weight, based on 100 parts by weight of the paste composition.

14. The paste composition for a front electrode of a solar cell according to claim 12, wherein the glass frit comprises SiO₂-PbO based powder, SiO₂-PbO-B₂O₃ based powder, Bi2O₃-B₂O₃-SiO₂ based powder, or a mixture thereof.

15. The paste composition for a front electrode of a solar cell according to claim 12, wherein the binder is at least one selected from the group consisting of i) a carboxylic acid group-containing photosensitive resin obtained by copolymerization of unsaturated carboxylic acid and a compound having an unsaturated double bond, ii) a carboxylic acid group-containing photosensitive resin obtained by addition of an ethylenic unsaturated group to a copolymer of unsaturated carboxylic acid and a compound having an unsaturated double bond as a pendant, iii) a carboxylic acid group-containing photosensitive resin obtained by reacting a compound having a hydroxyl group and an unsaturated double bond with a copolymer of acid anhydride having an unsaturated double bond and a compound having an unsaturated double bond.

16. The paste composition for a front electrode of a solar cell according to 12, wherein the solvent is at least one selected from the group consisting of α-terpineol, butyl carbitol acetate, texanol, butyl carbitol and dipropylene glycol monoethylether.

17. The paste composition for a front electrode of a solar cell according to 12, further comprising 1 to 20 parts by weight of at least one additive selected from the group consisting of a dispersant, a thickener, a thixotropic agent, and a leveling agent, based on 100 parts by weight of the paste composition.

18. A solar cell comprising
a silicon semiconductor substrate;
an emitter layer formed on the substrate;
an anti-reflection layer formed on the emitter layer;
a front electrode penetrating the anti-reflection layer from the top of the anti-reflection layer and connecting to the emitter layer; and
a rear electrode formed on the bottom of the substrate,
wherein the front electrode is formed using the paste composition comprising nano silver powder surface-treated with hexanoic acid according to any one of claims 12 to 17.

19. The solar cell according to claim 18, wherein the front electrode has the aspect ratio of 0.2 to 0.4.
